# DEMANDE DE BREVET EUROPEEN

(11) **EP 2 339 587 A1**
(43) Date de publication de la demande: **29.06.2011**
(21) Numéro de dépôt: 10196897.2
(22) Date de dépôt: 23.12.2010
(51) Int. Cl.: G11C 16/10, G11C 16/16

(54) **Sécurisation de l'effacement d'une memoire de type flashprom**

(30) Priorité: 23.12.2009 FR 0906273
(71) Demandeur: Thales, 92200 Neuilly Sur Seine (FR)
(72) Inventeur: Fazilleau, Grégory, 41100, VENDOME (FR); Guinier, Didier, 37390, NOTRE DAME D'OE (FR)
(74) Mandataire: Collet, Alain

(57) **Abrégé**

L'invention concerne un procédé de gestion de données destinées à être écrites à plusieurs reprises dans une mémoire organisée en secteurs nécessitant chacun un effacement complet d'une ancienne écriture pour permettre une nouvelle écriture dans le secteur. Pour sécuriser l'effacement de ce type de mémoire, le procédé consiste à ordonner les secteurs de la mémoire et pour chaque secteur, à réserver une zone d'entête destinée à recevoir un premier mot définissant que le dernier effacement du secteur a été correctement réalisé, et un second mot définissant qu'une procédure d'effacement est en cours pour le secteur précédent.

## Description

L'invention concerne un procédé de gestion de données destinées à être écrites à plusieurs reprises dans une mémoire organisée en secteurs nécessitant chacun un effacement complet d'une ancienne écriture pour permettre une nouvelle écriture dans le secteur.

On utilise des mémoires en lecture seule programmables rapides bien connues dans la littérature anglo-saxonne sons le nom de « FlashPROM ». Les mémoires de type FlashPROM sont particulièrement bien adaptées. Il s'agit de mémoires mortes très rapides et permettant le stockage d'un gros volume d'information sur une faible surface. Ces mémoires consomment peu d'énergie électrique. Ce type de mémoire est organisé en secteurs également appelés pages et en cours de fonctionnement, il n'est possible d'effacer les informations stockées qu'en effaçant au moins un secteur entier. Il n'est pas possible d'effacer une partie seulement d'un secteur. Les mémoires de type FlashPROM ne sont pas adaptées au stockage de données destinées à être modifiées en cours de fonctionnement lorsque ces données sont de taille inférieure à la taille d'un secteur. On se procure facilement des mémoires de type FlashPROM dont la taille des secteurs est comprise entre 1 et plusieurs dizaines de kilooctets. On comprend donc que ce type de mémoire n'est pas adapté pour des données de quelques octets et destinées à être modifiées.

L'invention s'intéresse aux données ayant une faible occurrence de lecture, écriture et effacement. A titre d'exemple, on peut citer les historiques de pannes survenant dans un système électronique.

Pour de telles données, on peut utiliser des mémoires en lecture seule effaçable électriquement bien connues dans la littérature anglo-saxonne sons le nom de « EEPROM ». Ce sont des mémoires mortes permettant le stockage, l'effacement et la réécriture de données individuelles de tailles variables. Par rapport aux mémoires de type FlashPROM, les mémoires de type EEPROM sont moins rapides, de moins grande capacité et consomment plus d'énergie électrique.

L'invention vise à permettre le stockage de données de taille inférieure à celle d'un secteur que l'on souhaite lire, écrire et effacer ou modifier dans une mémoire de type FlashPROM ou équivalente. L'invention s'intéresse plus particulièrement à la procédure d'effacement de ce type de mémoire. En effet, une séquence d'effacement dure typiquement plusieurs secondes, pendant lesquelles des incidents de fonctionnement peuvent se produire. Par exemple une coupure d'alimentation de la mémoire durant la séquence d'effacement peut interrompre la séquence.

Un objet de l'invention est de connaitre l'état d'effacement des secteurs de la mémoire au moyen d'une gestion d'entêtes de chaque secteur.

Un autre objet de l'invention est de permettre la reprise de l'effacement d'un secteur après interruption d'une séquence d'effacement de ce secteur.

Encore un autre objet de l'invention est de permettre une déclaration d'invalidité d'un secteur s'il n'est pas possible de reprendre la séquence d'effacement de ce secteur.

Dans un mode de réalisation préféré de l'invention, elle a pour objet un procédé de gestion de données destinées à être écrites à plusieurs reprises dans une mémoire organisée en secteurs nécessitant chacun un effacement complet d'une ancienne écriture pour permettre une nouvelle écriture dans le secteur, caractérisé en ce qu'il consiste à ordonner les secteurs de la mémoire et pour chaque secteur, à réserver une zone d'entête destinée à recevoir un premier mot définissant que le dernier effacement du secteur a été correctement réalisé, et un second mot définissant qu'une procédure d'effacement est en cours pour le secteur précédent.

L'invention est bien adaptée à la gestion de données dans une mémoire de type FlashPROM organisée en pages dont on ne peut effacer qu'une page. Il est également possible de regrouper plusieurs pages de la mémoire pour former un secteur selon l'invention. Dans ce cas, on ne prévoit qu'une seule zone d'entête pour un secteur formé d'un groupe de plusieurs pages.

La mise en oeuvre de l'invention permet de se passer d'une mémoire de type EEPROM en stockant les données qu'elle contient sur un autre type de mémoire, par exemple déjà partiellement utilisée pour stocker le programme permettant le fonctionnement d'un système électronique. En conséquence, l'invention permet de réduire le nombre de composants présent dans le système électronique et de réduire sa consommation électrique.

L'invention sera mieux comprise et d'autres avantages apparaîtront à la lecture de la description détaillée d'un mode de réalisation donné à titre d'exemple, description illustrée par le dessin joint dans lequel :
la figure 1 représente schématiquement un exemple de structuration de mémoire découpée en zones et en secteurs ;
la figure 2 représente schématiquement la structure d'un secteur particulier ;
la figure 3 représente schématiquement la structure d'une zone particulière.

Par souci de clarté, les mêmes éléments porteront les mêmes repères dans les différentes figures.

L'invention est décrite en rapport à une mémoire équipant un appareil électronique embarqué à bord d'un aéronef. Ce type de mémoire peut par exemple être utilisé pour mémoriser chronologiquement des incidents intervenant sur l'appareil.

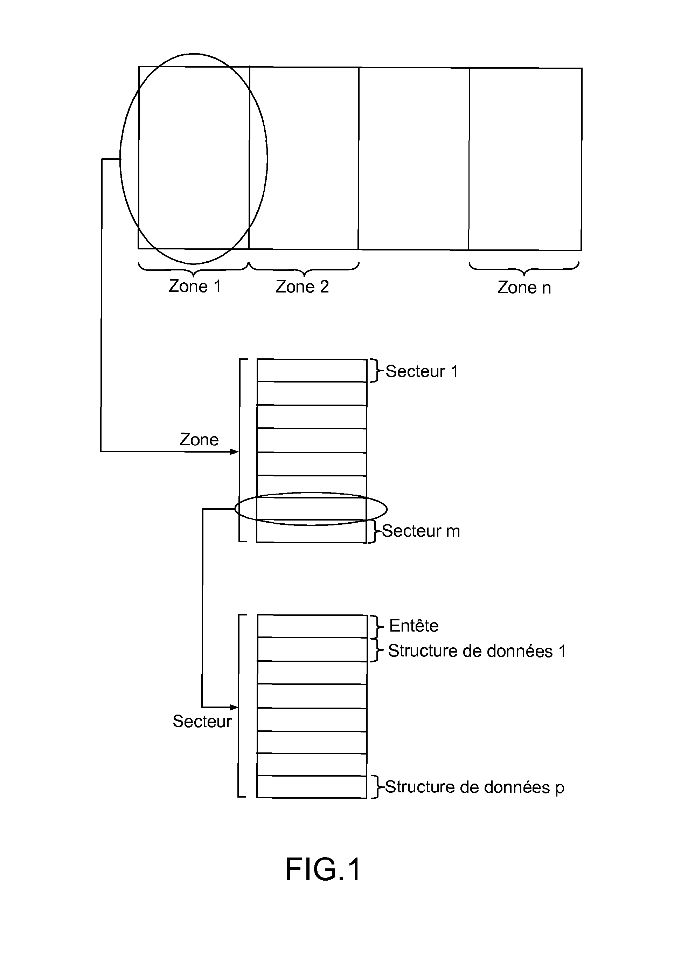

La figure 1 représente une mémoire que l'on a avantageusement découpée en plusieurs zones notées Zone 1, Zone 2 jusqu'à la zone n et contenant chacune plusieurs secteurs notés Secteur 1 à Secteur m. Chaque secteur est prévu pour stocker plusieurs données pouvant être écrites séparément. Il est possible de dédier les zones pour des utilisations différentes. Par exemple on pourra utiliser une zone pour mémoriser des contextes d'utilisation de l'appareil et une autre zone pour mémoriser des incidents. Chaque secteur nécessite un effacement complet d'une ancienne écriture pour permettre une nouvelle écriture dans ce secteur.

Avantageusement dans chaque secteur les différents emplacements notés Structure de données 1 à Structure de données p, prévus pour stocker les données ont tous la même taille et sont dimensionnés pour recevoir n'importe quelle donnée provenant de l'appareil, par exemple contexte ou incident selon la zone considérée. Les zones sont indépendantes et les tailles définies pour les emplacements de données peuvent différer d'une zone à l'autre.

Dans chaque secteur, on réserve une zone d'entête. La zone d'entête peut avoir la même taille que celle des structures de donnée du secteur considéré. La taille de l'entête peut être plus importante et on peut choisir comme taille de l'entête un multiple de la taille d'une structure de donnée de la zone considérée.

Dans une zone les secteurs sont ordonnés. On affecte aux secteurs d'une zone un rang, noté 1 à m sur la figure 1. L'ordonnancement est tournant. Autrement dit, le secteur suivant le dernier secteur m est le premier secteur 1.

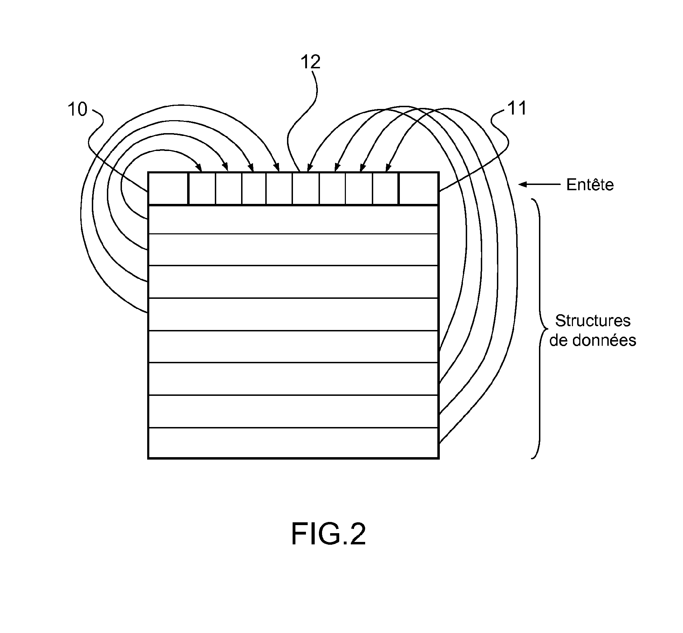

La figure 2 représente schématiquement la structure d'un secteur particulier et plus particulièrement la structure de l'entête de ce secteur.

La zone d'entête comprend un premier emplacement 10 destiné à recevoir un mot définissant que le dernier effacement du secteur a été correctement réalisé et un second emplacement 11 destiné à recevoir un second mot définissant qu'une procédure d'effacement est en cours pour le secteur précédant dans l'ordre défini pour la zone. Le mot du premier emplacement 10 sert avantageusement d'indication de début de secteur.

Plus précisément, pour effacer un secteur donné i, un procédé conforme à l'invention consiste à enchainer les opérations suivantes :
● écrire dans l'emplacement 11 du secteur suivant le secteur donné, c'est-à-dire dans l'emplacement 11 du secteur i+1, le mot précisant que la procédure d'effacement est commencée,
● effacer le secteur i,
● écrire dans l'emplacement 10 du secteur i le mot définissant que le dernier effacement du secteur a été correctement réalisé.

Lorsqu'un secteur d'une mémoire de type FlashPROM est effacé, tous les bits du secteur sont à un état logique 1. Il est possible de modifier l'état logique d'un seul bit pour l'amener à zéro. Il s'agit là d'une séquence d'écriture dans la mémoire qui peut donc être réalisée bit à bit. Par contre le passage d'un état logique 0 à un état logique 1 ne peut se faire que globalement pour l'ensemble d'un secteur. Il s'agit là d'une séquence d'effacement de la mémoire. Pour le mot écrit dans l'emplacement 10 définissant que le dernier effacement du secteur a été correctement réalisé, et pour le mot écrit dans l'emplacement 11 précisant que la procédure d'effacement est commencée, on choisira des mots différents d'un mot ne comprenant que des bits à l'état logique 1, état logique suivant immédiatement une séquence d'effacement pour une mémoire de type FlashPROM. Avantageusement, on choisira également des mots n'appartenant pas à l'ensemble des mots utilisés pour les données.

Il est possible de coder le mot écrit dans l'emplacement 11 sur deux bits. Une valeur « 1,1 » d'un mot du secteur i+1 correspond à l'état du mot avant le début de la procédure d'effacement du secteur i. Une valeur « 1,0 » correspond à l'état du mot au début de la procédure d'effacement du secteur i. Si un incident apparait lors de la procédure d'effacement du secteur i, par exemple une perte d'alimentation de la mémoire, alors on trouvera la valeur « 1,0 » à l'emplacement 11 du secteur i+1 et pas le mot définissant que le dernier effacement du secteur a été correctement réalisé à l'emplacement 10 du secteur i.

Une lecture de l'emplacement 10 du secteur i permettra de vérifier que la procédure d'effacement s'est ou ne s'est pas correctement déroulée pour le secteur i. La présence, à l'emplacement 10, du mot définissant que le dernier effacement du secteur a été correctement réalisé assure que la procédure d'effacement s'est correctement déroulée.

Lorsque l'emplacement 10 sert d'indication de début de secteur, l'effacement du secteur commence par cet emplacement. Pour une mémoire de type FlashPROM, la procédure d'effacement débute par l'emplacement 10 et dure plusieurs secondes En cas d'interruption de la procédure d'effacement le mot de l'emplacement 10 sera de façon quasi certaine effacé et sa lecture permettra de détecter un problème survenu durant la procédure d'effacement.

Si la procédure d'effacement n'a pas été menée à son terme, on peut envisager de la reprendre. Pour éviter de trop nombreuses reprises successives de la procédure d'effacement, on peut par exemple envisager de reprendre la procédure uniquement si celle-ci a été interrompue par une perte d'alimentation de la mémoire. Une autre condition possible est de limiter le nombre de reprise à une valeur donnée, par exemple une seule reprise.

Si la lecture de l'emplacement 10 ne donne pas le mot définissant que le dernier effacement du secteur a été correctement réalisé, même après une éventuelle reprise, on déclare le secteur i invalide. Pour mémoriser cette déclaration d'invalidité, on peut utiliser l'emplacement 11 du secteur i+1 en y écrivant la valeur « 0,0 ». Le fait d'utiliser pour la déclaration d'invalidité du secteur courant i un autre secteur, en l'occurrence le secteur i+1 permet de ne plus considérer le secteur déclaré invalide et ainsi de ne pas risquer une erreur d'interprétation lors de la lecture du secteur invalide.

Avantageusement, pour éviter de relire plusieurs fois le mot écrit à l'emplacement 10 dans un secteur déclaré invalide, on peut supprimer ce secteur dans l'ordonnancement des secteurs de la mémoire. Le réordonnancement de la mémoire se fait au moment de l'effacement du secteur i+1 afin de remettre à l'emplacement 11 la valeur « 1,1 ».

Une zone de la mémoire contient plusieurs secteurs, par exemple huit. On peut se fixer un seuil prédéfini de nombre de secteurs déclarés invalides. Si le nombre de secteurs invalides dépasse le seuil prédéfini, on déclare la mémoire invalide. On peut également préciser ce seuil pour chaque zone de la mémoire et vérifier le dépassement de seuil pour chaque zone de la mémoire. Si à l'intérieur d'une zone de la mémoire, le seuil prédéfini est dépassé, on déclare seulement la zone invalide. Les autres zones restent alors utilisables.

Les historiques de pannes ou des modifications de contexte survenant dans un système électronique peuvent être stockés de façon tournante. Plus précisément, les dernières données remplacent les données les plus anciennes. On conserve ainsi un historique remontant sur un nombre déterminé d'évènements, ce nombre étant déterminé par la taille de la mémoire allouée à ces données. La gestion de ce type de données est souvent appelée table tournante.

La zone d'entête de chaque secteur comprend par ailleurs, un troisième emplacement 12 destiné à recevoir un mot définissant le remplissage du secteur.

On définit dans chaque secteur des emplacements destinés à recevoir chacun une donnée et on associe à chaque emplacement de donnée une partie de l'emplacement 12 de la zone d'entête. La partie de la zone d'entête est destinée à être écrite lorsqu'une donnée est stockée dans l'emplacement correspondant. Un bit suffit pour chaque partie. Autrement dit, on associe à chaque emplacement de donnée un bit dans l'emplacement 12. Pour la gestion d'une table tournante, les données sont écrites chronologiquement. Les emplacements de données sont également ordonnés dans un secteur. Il est donc aisé d'associer les bits de l'emplacement 12 aux emplacements de données dans le même ordre. Cette association ordonnée est symbolisée sur la figure 2 par des flèches curvilignes.

Après effacement d'un secteur, tous les bits de ce secteur sont à l'état logique 1, et en particulier ceux de l'emplacement 12. Lorsqu'on procède à l'écriture d'une donnée dans un emplacement de donnée, on écrit une valeur « 0 » dans le bit correspondant de l'emplacement 12. Il est important de ne pas disjoindre ces deux écritures dans l'emplacement de donnée et dans l'emplacement 12 afin de permettre un suivi ultérieur du remplissage du secteur par une simple lecture de l'emplacement 12.

Si les bits de l'emplacement 12 sont dans le même ordre que l'ordre d'écriture des données, alors les bits de l'emplacement 12 passent les uns à la suite des autres de l'état logique 1 à l'état logique 0 lors du remplissage du secteur. Pour déterminer le prochain emplacement de donnée dans lequel on pourra écrire, il suffit de lire dans l'ordre les bits de l'emplacement 12. Le premier bit dont l'état logique est 1 correspond au premier emplacement de donnée libre.

Dans un secteur donné une lecture chronologique des bits de l'emplacement 12 permet de déterminer le taux de remplissage du secteur considéré. Les secteurs étant ordonnés, en lisant successivement, dans l'ordre des secteurs, les mots de remplissage stockés dans les différents emplacements 12, on détermine le premier secteur non complet et dans ce secteur le premier emplacement de donnée disponible.

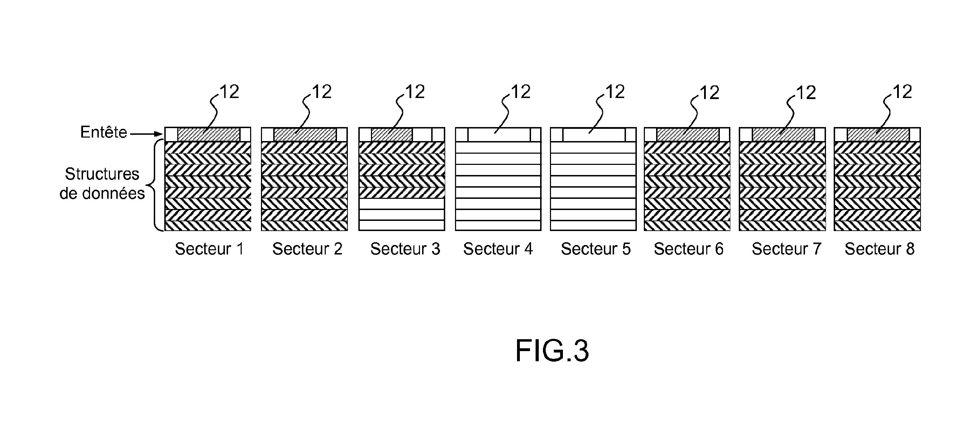

La figure 3 représente schématiquement la structure d'une zone particulière de la mémoire. La figure 3 permet d'illustrer l'effacement des données les plus anciennes afin d'assurer à la mémoire un fonctionnement sous forme de table tournante. La zone représentée figure 3 comprend huit secteurs comprenant chacun une zone d'entête et huit emplacements de données notés « Structure de données ». Il est bien entendu que les nombres de secteurs et d'emplacements de données ne sont donnés qu'à titre d'exemple. Des hachures disposées dans les emplacements de données symbolisent des emplacements occupés par des données et inversement, les emplacements de données non hachurés symbolisent des emplacements de données libres. Dans l'exemple représenté, les secteurs 1, 2, 6, 7 et 8 sont complètement occupés par des données et les secteurs 4 et 5 sont complètement libres. Les cinq premiers emplacements de données du secteur 3 sont occupés et les trois derniers emplacements de données du secteur 3 sont libres. Les emplacements 12 de chaque secteur ont été grisés pour représenter le remplissage des secteurs correspondants.

On prédéfinit un nombre de secteurs devant rester complètement libre, par exemple 2. On lit pour l'ensemble de la mémoire, ou pour une zone de la mémoire si la mémoire est découpée en zones, les mots définissant le remplissage des différents secteurs dans les emplacements 12, pour déterminer un nombre de secteurs dans lesquels tous les emplacements de données sont libres. Si le nombre de secteurs dans lesquels tous les emplacements de données sont libres est supérieur ou égal à 2, alors on peut continuer la mémorisation des données dans le secteur en cours de remplissage, ici le secteur 3. Si au contraire le nombre de secteurs dans lesquels tous les emplacements de données sont libres est inférieur au nombre prédéfini, 2 dans l'exemple, alors on efface le secteur contenant les données mémorisées les plus anciennes. Dans l'exemple représenté, cette condition sera remplie dès l'écriture d'une donnée dans le premier emplacement de donnée du secteur 4. Le remplissage des secteurs se faisant dans l'ordre des secteurs, les données les plus anciennes sont stockées dans le secteur 6. Pour déterminer ce secteur on peut par exemple lors d'une lecture des mots de remplissage stockés dans les différents emplacements 12 rechercher le premier mot dont les bits sont à « 0 » et qui suit un mot dont les bits sont à « 1 ». Lorsque ce secteur est déterminé, on peut lancer la séquence d'effacement de ce secteur.

Lorsque l'on détecte qu'une séquence d'effacement est nécessaire, et qu'une donnée doit être écrite, on commence par effectuer l'écriture de la donnée. Ensuite, on efface le secteur le plus ancien. Lors de l'effacement, un statut de la mémoire prend une valeur dite « occupée », ce qui empêche toute autre utilisation de la mémoire, notamment pour une écriture d'une nouvelle donnée. Si pendant la procédure d'effacement, des données sont présentées pour être écrites, on peut prévoir de les stocker temporairement, par exemple dans une mémoire volatile, en attendant que la procédure d'effacement soit terminée. Une fois la procédure d'effacement, terminée, le statut de la mémoire prend une valeur dite « libre » et l'écriture des données peut se dérouler comme indiqué précédemment.

## Revendications

1. Procédé de gestion de données destinées à être écrites à plusieurs reprises dans une mémoire organisée en secteurs nécessitant chacun un effacement complet d'une ancienne écriture pour permettre une nouvelle écriture dans le secteur, **caractérisé en ce qu'**il consiste à ordonner les secteurs de façon tournante dans la mémoire, le secteur suivant le dernier secteur étant le premier secteur, et pour chaque secteur, à réserver une zone d'entête destinée à recevoir un premier mot définissant que le dernier effacement du secteur a été correctement réalisé, et un second mot définissant qu'une procédure d'effacement est en cours pour le secteur précédent.

2. Procédé selon la revendication 1, **caractérisé en ce que** le mot du premier emplacement (10) sert d'indication de début de secteur.

3. Procédé selon l'une des revendications précédentes, **caractérisé en ce qu'**il consiste pour effacer un secteur donné à enchainer les opérations suivantes :
● écrire dans le secteur suivant le secteur donné, le second mot,
● effacer le secteur donné,
● écrire dans le secteur donné le premier mot.

4. Procédé selon la revendication 3, **caractérisé en ce que** si après une procédure d'effacement d'un secteur, lors d'une lecture du premier emplacement (10) de ce secteur on ne trouve pas le premier mot, alors on relance la procédure d'effacement.

5. Procédé selon l'une quelconque des revendications 3 ou 4, **caractérisé en ce qu'**il consiste pour écrire des données distinctes de l'entête dans un secteur donné, à vérifier l'exactitude du premier mot avant d'écrire les données, et **en ce que** si le premier mot du secteur donné n'est pas exact, à déclarer le secteur invalide et **en ce qu'**une déclaration d'invalidité du secteur donné (i) est faite dans le secteur suivant (i+1).

6. Procédé selon la revendication 5, **caractérisé en ce que** la déclaration d'invalidité du secteur donné est faite à l'emplacement du second mot.

7. Procédé selon l'une quelconque des revendications 5 ou 6, **caractérisé en ce qu'**un secteur déclaré invalide est supprimé dans l'ordonnancement des secteurs de la mémoire.

8. Procédé selon l'une quelconque des revendications 5 à 7, **caractérisé en ce qu'**il consiste à compter le nombre de secteurs invalides et **en ce que** si le nombre de secteurs invalides dépasse un seuil prédéfini, à déclarer la mémoire invalide.

9. Procédé selon l'une quelconque des revendications 5 à 8, **caractérisé en ce qu'**il consiste à découper la mémoire en plusieurs zones contenant chacune plusieurs secteurs, et **en ce que** pour chacune des zones de la mémoire, si le nombre de secteurs invalides dépasse un seuil prédéfini, à déclarer la zone de la mémoire invalide.

10. Procédé selon l'une des revendications précédentes, **caractérisé en ce qu'**il consiste à :
● pour chaque secteur, réserver dans la zone d'entête un troisième emplacement (12) destinée à recevoir un mot définissant le remplissage du secteur,
● définir dans chaque secteur des emplacements (1 à p) destinés à recevoir chacun une donnée,
● et à associer à chaque emplacement de donnée une partie du troisième emplacement (12),
la partie du troisième emplacement (12) étant destinée à être écrite lorsqu'une donnée est stockée dans l'emplacement de donnée correspondant.

11. Procédé selon la revendication 10, **caractérisé en ce que** les parties du troisième emplacement (12) associées aux emplacements de données occupent chacune un bit, **en ce que** la valeur du bit après effacement est associée au fait que l'emplacement de donné correspondant est libre, et **en ce que** la valeur inverse du bit est associée au fait que l'emplacement de donné correspondant est occupé.

12. Procédé selon l'une quelconques des revendications 10 ou 11, **caractérisé en ce qu'**il consiste à :
● lire successivement dans l'ordre des secteurs (1 à m) les mots (12) définissant le remplissage de chaque secteur,
● déterminer le premier secteur non complet, et dans ce secteur le premier emplacement de donnée disponible,
● écrire une donnée dans le premier emplacement de donnée disponible,
● et écrire dans la partie de la zone d'entête associée au premier emplacement de donnée disponible une valeur définissant que l'emplacement de donné est occupé.

13. Procédé selon l'une quelconques des revendications 10 à 12, **caractérisé en ce qu'**il consiste à :
● lire pour l'ensemble de la mémoire, les mots (12) définissant le remplissage des différents secteurs (1 à 8), pour déterminer un nombre de secteurs (4 et 5) dans lesquels tous les emplacements de données sont libres,
● si ce nombre de secteur est inférieur à un nombre prédéfini, effacer le secteur (6) contenant les données mémorisées les plus anciennes.
